# EUROPÄISCHE PATENTANMELDUNG

(11) **EP 1 992 953 A2**
(43) Veröffentlichungstag der Anmeldung: **19.11.2008**
(21) Anmeldenummer: 08009088.9
(22) Anmeldetag: 16.05.2008
(51) Int. Cl.: G01R 11/04, H02B 1/03

(54) **Zähleranschlussplatz mit einer Zählertragplatte zur Aufnahme von mindestens zwei Stromzählern**

(30) Priorität: 16.05.2007 DE 102007023077
(71) Anmelder: Hager Electro GmbH & Co. KG, 66131 Saarbrücken (DE)
(72) Erfinder: Gouth, Fernand, 57410 Rohrbach-les-Bitche (FR); Zimmermann, Michael, 66399 Mandelbachtal (DE); Kelaiditis, Konstantin, Dr. Ing., 66386 St. Ingbert (DE)
(74) Vertreter: Bernhardt, Reinold

(57) **Zusammenfassung**

Die Erfindung betrifft einen Zähleranschlussplatz mit einer Zählertragplatte (2) zur Aufnahme von wenigstens zwei Stromzählern (5,6). Erfindungsgemäß ist die Zählertragplatte (2) an einer dahinterliegenden weiteren Zählertragplatte (3) angebracht. Durch Befestigung der Zählertragplatte an der dahinterliegenden Tragplatte, lässt sich ein Zähleranschlussplatz für nur einen Stromzähler mit geringem Aufwand in einen Zähleranschlussplatz für zwei oder mehr Stromzähler umrüsten.

## Beschreibung

Die Erfindung betrifft einen Zähleranschlussplatz mit einer Zählertragplatte zur Aufnahme von mindestens zwei Stromzählern.

Eine Zählertragplatte mit zwei Anschlusssystemen für je einen Stromzähler ist aus der DE 103 59 139 A1 bekannt.

Zusätzlich zu den Energieverbrauch messenden Stromzählern werden in zunehmendem Maße weitere Stromzähler zur Messung von Stromenderzeugern dezentral, z.B. durch Photovoltaikanlagen, ins Stromnetz eingespeister Elektroenergie benötigt. In den Haushalten von Endverbrauchern, die selbst auch Strom erzeugen, sind jedoch normalerweise keine Aufnahmeplätze für weitere Stromzähler verfügbar. Deren Installation erfordert zusätzlichen Raum, z.B. für zusätzliche Zählerschränke.

Der vorliegenden Erfindung liegt die Aufgabe zugrunde, die Installation weiterer Stromzähler zu erleichtern.

Der diese Aufgabe lösende Zähleranschlussplatz nach der Erfindung ist dadurch gekennzeichnet, dass die Zählertragplatte für die Aufnahme von wenigstens zwei Stromzählern an einer dahinterliegenden weiteren Zählertragplatte angebracht ist.

Vorteilhaft lässt sich durch die Erfindung mit geringem Aufwand bereits vorhandener Installationsraum zum Anschluss weiterer Stromzähler nutzen.

Erfindungsgemäß wird an einer herkömmlichen, bereits vorhanden Tragplatte für beispielsweise einen einzelnen Ferraris-Stromzähler, z.B. einer Tragplatte mit Abmessungen gemäß DIN 43870, eine Zählertragplatte für zwei oder mehr Stromzähler, vergleichsweise kleine elektronische Stromzähler, angebracht. Aufwendige Umbaumaßnahmen an bestehenden Anlagen, die den Austausch einer Zöhlertragplatte oder eines ganzen Trägerfeldes notwendig machen, sind nicht mehr erforderlich. Die erfindungsgemäße Zählertragplatte wird auf eine bereits installierte Zählertragplatte einfach aufgesetzt und daran befestigt.

Vorzugsweise ist die Zählertragplatte parallel zu der weiteren Zählertragplatte angeordnet und mit dieser deckungsgleich oder geringfügig kleiner als die weitere Zählertragplatte.

Insbesondere kann die Zählertragplatte, ggf. klemmend, zwischen Randstegen der weiteren Zählertragplatte eingesetzt werden, z.B. in einen durch einen umlaufenden Randsteg gebildeten Rahmen.

Die Tragplatte kann derart auf die weitere Zählertragplatte aufsteckbar sein, dass sie dort einrastet und selbständig hält.

Zweckmäßig ist die zur Aufnahme von mindestens zwei Stromzählern geeignete Tragplatte so gestaltet, dass sie an herkömmlichen Zählertragplatten verschiedener Hersteller verschiedener Abmessungen und verschiedener Bauformen angebracht, die Tragplatte also universell verwendet werden kann.

In vorteilhafter Ausgestaltung der Erfindung ist die weitere Zählertragplatte durch die Tragplatte vollständig abgedeckt. Um den Zugriff von außen weiter zu erschweren, kann die Tragplatte ferner mit einem ggf. geschlossen umlaufenden Randsteg gegen die weitere Zählertragplatte anliegen, so dass ein zwischen den Platten gebildeter Hohlraum nicht zugänglich ist.

Als Mittel zur Befestigung der Tragplatte an der weiteren Zählertragplatte in Betracht kommen z.B. Schrauben, die in Bohrungen in der weiteren Zählertragplatte eingreifen. Solche Schraubverbindungen lassen sich vor Ort mit geringem Aufwand herstellen.

Zweckmäßig kann zur Befestigung der Tragplatte ein an der weiteren Zählertragplatte ggf. vorhandenes Zählerkreuz genutzt werden.

An der Tragplatte können als Gesamtheit montierbare Aufnahmebaugruppen für die beiden Stromzähler vorgesehen sein, wobei die Aufnahmebaugruppen vorzugsweise sämtliche zur elektrischen und mechanischen Ankopplung des Stromzählers erforderlichen Elementen aufweisen. Tragplatten mit solchen Aufnahmebaugruppen sind in der hier einbezogenen Patentanmeldung DE 103 59 139 A1 beschrieben.

Die Aufnahmebaugruppen, die vorzugsweise ein im Wesentlichen quaderförmiges Gehäuse aufweisen, können in Öffnungen in der Zählertragplatte einsenkbar oder auf die Zählertragplatte aufsetzbar sein.

Zwischen den versenkbaren Aufnahmebaugruppen ist vorzugsweise ein Verdrahtungskanal gebildet, während die auf die Zählertragplatte aufsetzbaren Aufnahmebaugruppen unter Verringerung der Breite der Zählertragplatte unmittelbar aneinander angrenzend angeordnet sein können.

In einer Ausführungsform der Erfindung weisen die Aufnahmebaugruppen jeweils an einander gegenüberliegenden Seiten permanent angebrachte Anschlussleitungen auf. Alternativ können an den gegenüberliegenden Seiten Klemmen, vorzugsweise Klemmleisten, für den Anschluss von Leitungen vorgesehen sein, wobei insbesondere auf der einen Seite ungezählten Strom führende Leitungen und auf der anderen Seite gezählten Strom führende Leitungen anschließbar sind.

Vorzugsweise in der Ausführungsform mit auf die Zählertragplatte aufsetzbaren Aufnahmebaugruppen weist die Zählertragplatte eine Öffnung für die Durchführung der angeschlossenen Leitungen auf.

Zweckmäßig sind Schwachstellen zur Bildung der Öffnung in unterschiedlicher Größe oder/und unterschiedlicher Anordnung vorgesehen.

In weiterer Ausgestaltung der Erfindung ist die Tragplatte zur Aufnahme von weiteren, vorzugsweise der Datenübertragung dienenden, Geräten oder zur Aufnahme von Schaltvorrichtungen vorgesehen. Solche Geräte können z.B. durch die elektronischen Stromzähler ermittelte Daten direkt an die betreffenden Stromversorgungsunternehmen oder die Stromabnehmer übertragen.

Am oberen Ende der Zählertragplatte sind zweckmäßig von der Zählertragplatte in Form eines umlaufenden Stegs vorstehende Wände zur Bildung eines separaten, vorzugsweise durch eine Abdeckung verschließbaren Aufnahmeraums für die Geräte vorgesehen. Zweckmäßig lässt sich die Öffnung mit einer Öffnung zum Durchführen von Leitungen in der weiteren Zählertragplatte zur Deckung bringen.

In dem den Aufnahmeraum bildenden Steg können Schwachstellen für die Bildung von Öffnungen vorgesehen sein, durch welche hindurch die Aufnahmebaugruppen in den Aufnahmeraum hineinragen. Vorteilhaft können so mit der Abdeckung des Aufnahmeraums auch die an den an die Aufnahmebaugruppe angeschlossenen Leitungen abgedeckt werden.

Die Erfindung wird nachfolgend anhand von Ausführungsbeispielen und der beiliegenden, sich auf diese Ausführungsbeispiele beziehenden Zeichnungen näher erläutert. Es zeigen:
- Fig. 1: einen Zähleranschlussplatz nach der Erfindung, der neben einem herkömmlichen Zähleranschlussplatz für einen elektromechanischen Zählers angeordnet ist,
- Fig. 2: die Zählerplätze von Fig. 1, angeordnet in einem Zählerschrank, in einer Querschnittsdarstellung,
- Fig. 3: eine der Fig. 2 entsprechende Anordnung mit einem weiteren Zähleranschlussplatz nach der Erfindung,
- Fig. 4: eine Zählertragplatte für einen Zähleranschlussplatz entsprechend einem dritten Ausführungsbeispiel für die vorliegende Erfindung in perspektivischer Ansicht,
- Fig. 5: die Zählertragplatte von Fig. 4 in einer weiteren perspektivischen Ansicht,
- Fig. 6: den die Tragplatte von Fig. 1 aufweisenden Zähleranschlussplatz nach der Erfindung mit zwei auf der Tragplatte angeordneten Aufnahmebaugruppen für je einen elektronischen Stromzähler in perspektivischer Ansicht,
- Fig. 7: den Zähleranschlussplatz von Fig. 6 mit nur einer Aufnahmebaugruppe für einen elektronischen Stromzähler,
- Fig. 8: den Zähleranschlussplatz der vorangehenden Figuren mit nur einer den Aufnahmebaugruppen von Fig. 7 und 8 entsprechenden Aufnahmebaugruppe,
- Fig. 9: den Zähleranschlussplatz von Fig. 6 mit einer der Aufnahmebaugruppe von Fig. 7 und 8 unterschiedlichen Aufnahmebaugruppe, und
- Fig. 10 und 11: zwei weitere Ausführungsbeispiele für einen Zähleranschlussplatz nach der Erfindung.

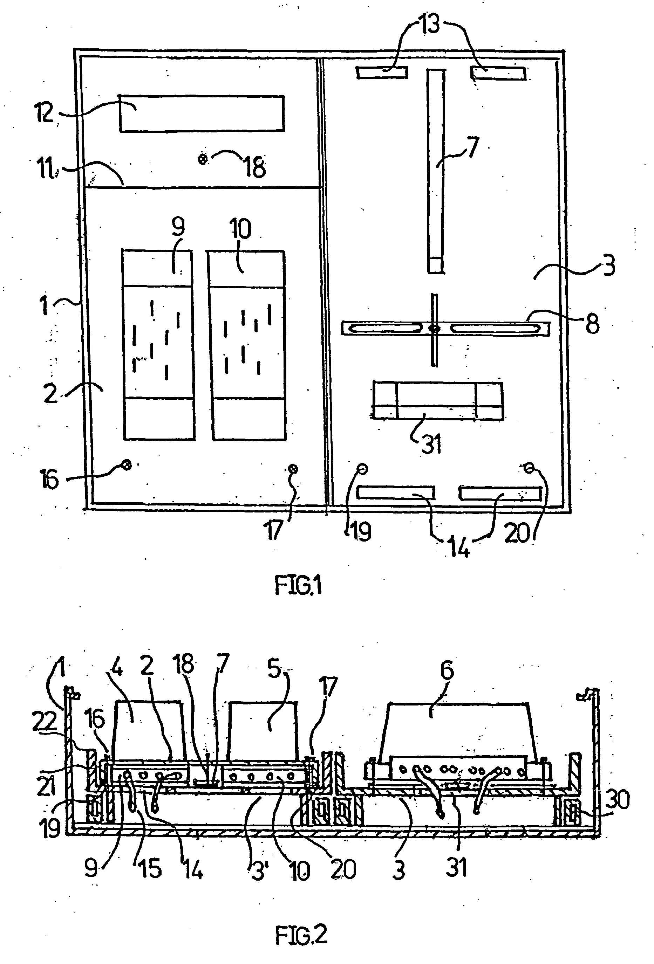

Gemäß Fig. 2 sind in einem Zählerschrank 1 zwei in Fig. 1 gezeigte Zähleranschlussplätze mit jeweils einer Zählertragplatte 2 bzw. 3 an Halteschienen 30 des Zählerschranks 1 befestigt. Die Zählertragplatte 2 kann zwei elektronische Stromzähler 4 und 5 aufnehmen, die Zählertragplatte 3 dient der Aufnahme eines herkömmlichen elektromechanischen Stromzählers 6. Der elektromechanische Stromzähler 6 lässt sich an einem Zählerkreuz mit einem vertikalen Schenkel 7 und einem horizontalen Schenkel 8 befestigen. Durch eine Öffnung 31 hindurch können Anschlussleitungen für den elektromechanischen Stromzähler 6 geführt werden.

Die Zählertragplatte 2 ist mit zwei die elektronischen Stromzähler 4 und 5 tragenden Aufnahmebaugruppen 9 und 10 verbunden, die jeweils alle zur elektrischen und mechanischen Ankopplung der Stromzähler erforderlichen Elemente umfassen. Etwa im oberen Drittel der Zählertragplatte 2 ist ein durch einen umlaufend vorstehenden Steg 11 abgetrennter Bereich für die Aufnahme von Geräten 12 vorgesehen, die z.B. der Übermittlung von Daten dienen.

Hinter der Zählertragplatte 2 befindet sich eine weitere Zählertragplatte 3', welche mit der Zählertragplatte 3 übereinstimmt und am oberen und unteren Rand Öffnungen 13 bzw. 14 für die Durchführung mit den Aufnahmebaugruppen 9 und 10 permanent oder lösbar verbundener Leitungen 15 aufweist. Die Zählertragplatte 2 ist an der Zählertragplatte 3' mit Hilfe von Schrauben 16 bis 18 befestigt, wobei die Schrauben 16 und 17 in Bohrungen 19 und 20 in der Tragplatte 3' eingedreht sind und die Schraube 18 an dem vertikalen Zählerkreuzschenkel 7 angebracht ist.

Wie Fig. 2 ferner erkennen lässt, sitzt die Zählertragplatte 2 auf der Zählertragplatte 3' mit einem umlaufenden Randsteg 21 auf, sodass zwischen der Zählertragplatte 2 und der Zählertragplatte 3' ein Teile der Aufnahmebaugruppen 9 und 10 aufnehmender, von außen unzugänglicher Hohlraum gebildet ist.

Mit dem umlaufenden Randsteg 21 lässt sich die Zählertragplatte 2, ggf. klemmend, in die einen umlaufenden Randsteg 22 aufweisende Zählertragplatte 3' einsetzen.

Zur Bildung des die Zählertragplatte 2 aufweisenden Zählerplatzes werden die Öffnungen 13 und 14 sowie die Bohrungen 19 und 20 vor Ort hergestellt und die Zählertragplatte 2 einfach auf die Zählertragplatte 3' aufgeschraubt, wobei die Leitungen 15 durch die jeweiligen Öffnungen 13 und 14 geführt werden. Zur Schraubbefestigung können plombierbare oder unlösbare Schrauben zum Einsatz kommen.

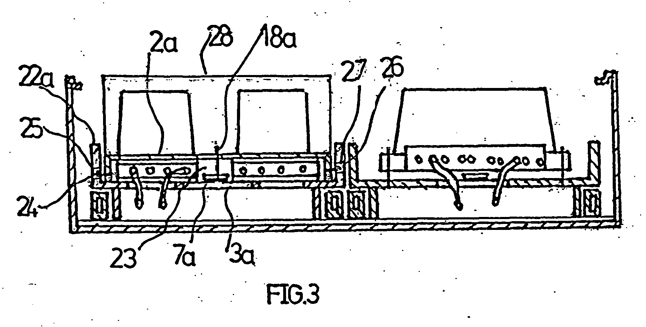

Das Ausführungsbeispiel von Fig. 3 unterscheidet sich von dem vorangehenden Ausführungsbeispiel dadurch, dass eine Zählertragplatte 2a in ihrem unteren Bereich nicht durch zwei Schrauben an einer Zählertragplatte 3a' befestigt ist, sondern durch Haken 24 und 26, die in Öffnungen 25 und 27 in einem umlaufenden Randsteg 22a der Zählertragplatte 3a' einrasten. Die Öffnungen 25 und 27 lassen sich ohne Weiteres vor Ort herstellen.

Eine Haube 28 dient zur Abdeckung der Geräte 12 in dem abgetrennten Bereich. Zwischen den zueinander im Abstand angeordneten Aufnahmebaugruppen 9 und 10 ist ein Verdrahtungskanal 23 gebildet.

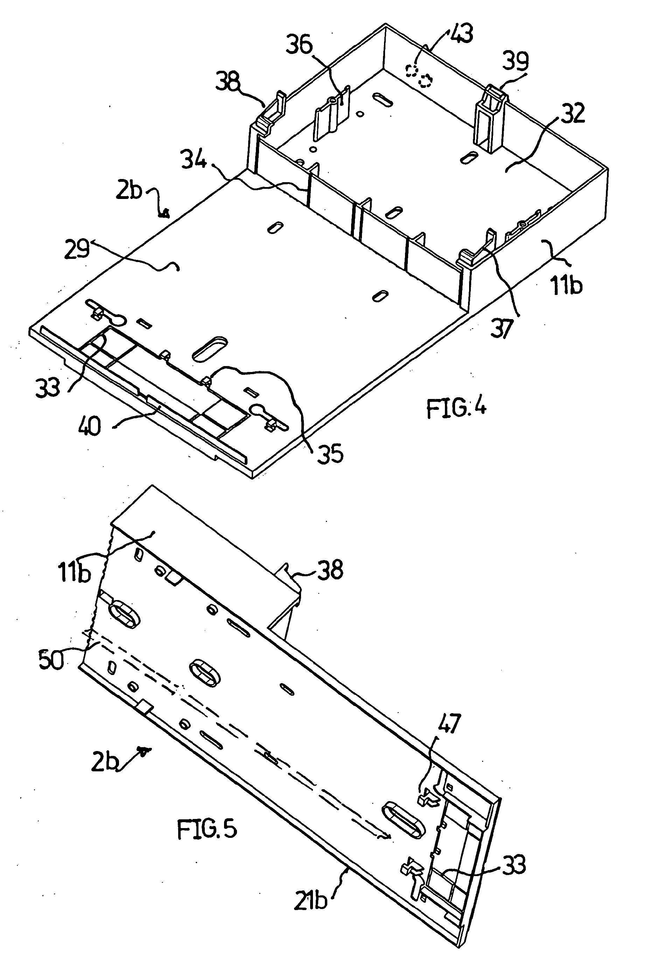

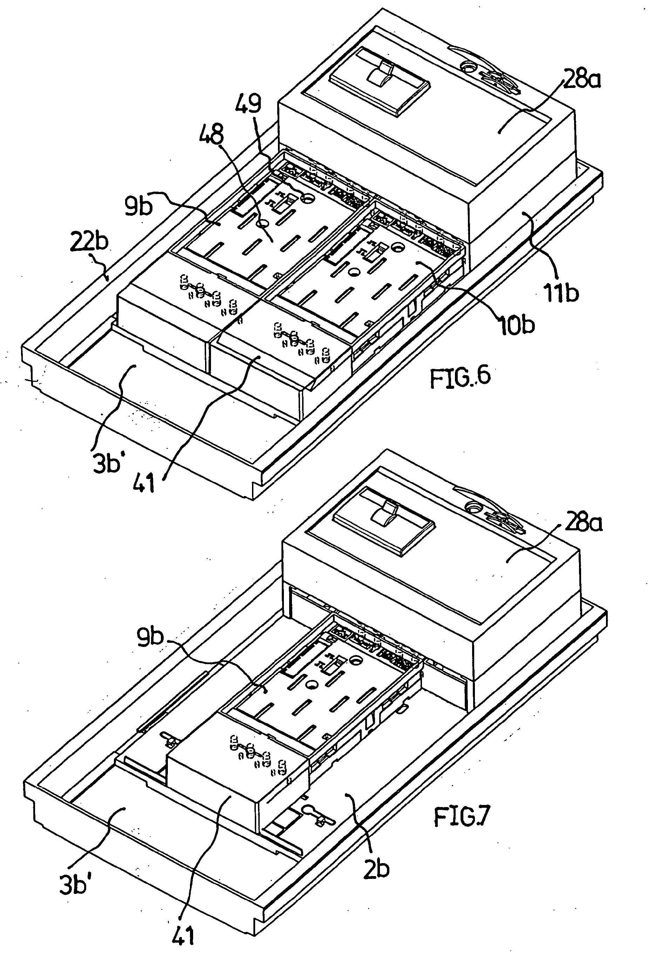

Eine in den Fig. 4 und 5 gesondert dargestellte Zählertragplatte 2b weist im Unterschied zu den vorangehend gezeigten Zählertragplatten 2 und 2a keine Öffnungen, in die hinein Aufnahmebaugruppen versenkbar sind, sondern eine Aufnahmefläche 29 für zwei Aufnahmebaugruppen 9b und 10b auf, die von der Aufnahmefläche 29 vorstehen (Fig. 6).

An der der Aufnahmefläche 29 abgewandten Seite der Zählertragplatte 2b steht an drei Randseiten ein Randsteg 21 b vor. Weitere Rippen bzw. Stege 50 können der Bildung von Kabelführungen dienen. Oberhalb der Aufnahmefläche 29 erstreckt sich von der Zählertragplatte 2b ein umlaufender, einen separaten Aufnahmeraum 32 für Geräte bildender Steg 11 b. Unterhalb der Aufnahmefläche 29 sind Schwachstellen 33 zum Ausbrechen einer Durchgangsöffnung in der Zählertragplatte 2b gebildet, wobei die Schwachstellen den Ausbruch unterschiedlich großer und in unterschiedlichen Positionen angeordneter Durchgangsöffnungen ermöglichen.

Weitere Schwachstellen 34 zum Ausbrechen von Öffnungen in unterschiedlichen Positionen befinden sich in dem der Aufnahmefläche 29 zugewandten Wandabschnitt des Stegs 11 b.

Wie die Fig. 4 und 5 zeigen weist die Zählertragplatte 2b an verschiedenen Stellen als Langlöcher ausgebildete Öffnungen zur Befestigung der Zählertragplatte an einer weiteren Zählertragplatte 3b' (Fig. 6-9) sowie zur Befestigung der Aufnahmebaugruppen 9b,10b auf der Tragfläche 29 auf. Zur Befestigung der Aufnahmebaugruppen 9b, 10b auf der Zählertragplatte 2b dient ferner eine Reihe von der Trägerfläche 29 vorstehender Haken 35. Der Hakenreihe gegenüberliegend sind Stege 40 als Anschlag für Abdeckungen angeordnet.

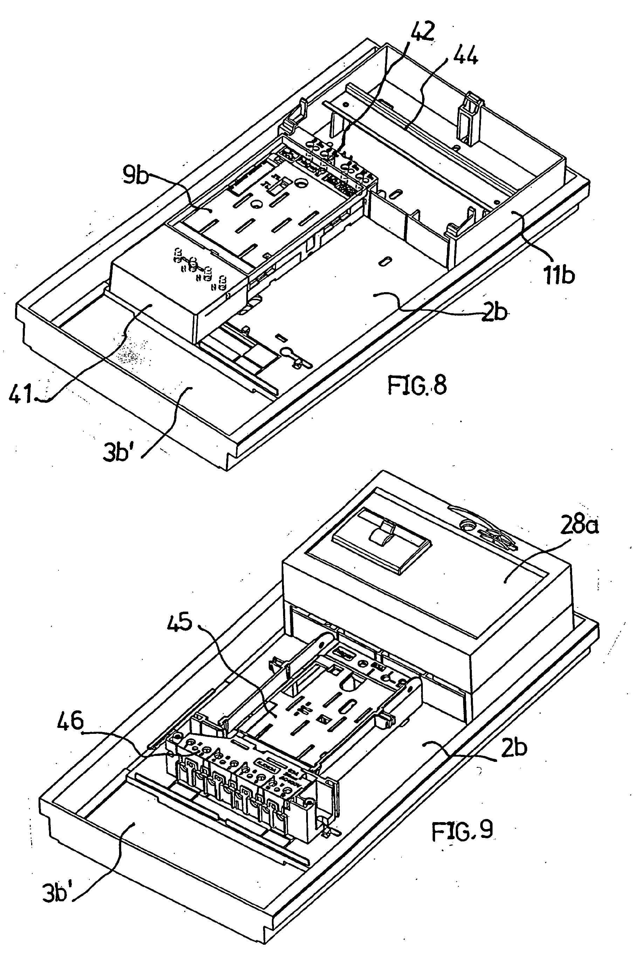

An zwei Trägerböcken 36, die innerhalb des separaten Aufnahmeraums 32 von der Zählertragplatte 2b vorstehen, lässt sich eine Hutprofilschiene 44 (Fig. 8) für die Aufnahme der genannten Geräte befestigen. Die Bezugszeichen 37,38 und 39 weisen auf Einrichtungen zur Befestigung einer Abdeckung 28a für den separaten Geräteaufnahmeraum 32 hin.

Zwei an der der Aufnahmefläche 29 gegenüberliegenden Seite der Zählertragplatte 2b vorgesehene Haken 47 dienen der Befestigung der Zählertragplatte 2b an horizontalen Zählerkreuzschenkeln 8 an der weiteren Zählertragplatte 3b' oder 3.

Wie die Fig. 6 bis 9 erkennen lassen, bildet die weitere Zählertragplatte 3b' den Boden einer Wanne mit einem umlaufenden Randsteg 22b.

Das Bezugszeichen 41 bezeichnet Hauben zum Abdecken von Leitungen, die an die Aufnahmebaugruppen 9b und 10b angeschlossen sind.

Die Aufnahmebaugruppen 9b und 10b weisen jeweils eine Trägerfläche 48 für die Aufnahme eines in einer Steck- und Verschiebebewegung an der Aufnahmebaugruppe anbringbaren elektronischen Stromzählers auf. Am oberen Ende der Aufnahmebaugruppen 9b,10b ist eine Klemmanschlussleiste 42 für gezählten Strom führende Leitungen vorgesehen. Eine Klemmanschlussleiste für ungezählten Strom führende Leitungen befindet sich an der gegenüberliegenden unteren Seite des etwa quaderförmigen Gehäuses der Aufnahmebaugruppen 9b,10b, wobei diese Klemmleisten jeweils durch eine der Hauben 41 a abgedeckt sind.

Zur Montage der beiden in Fig. 6 gezeigten Aufnahmebaugruppen 9b,10b auf der Zählertragplatte 2b werden mit Hilfe der Schwachstellen 34 in dem Steg 11 b Öffnungen ausgebrochen, durch welche hindurch die Aufnahmebaugruppen 9b,10b mit ihren oberen Enden in den separaten Aufnahmeraum 32 hineinragen. Die am unteren Ende an den Haken 35 angebrachten Aufnahmebaugruppen 9b,10b lassen sich nahe ihrem oberen Ende mit Hilfe durch das Gehäuse der Aufnahmebaugruppen geführter Drehbolzen 49 an der Zählertragplatte 2b befestigen. An der Klemmanschlussleiste 42 angebrachte Leitungen für gezählten Strom können durch Öffnungen bei 43 in dem Steg 11 b hindurchgeführt werden, wobei sich die Öffnungen 43 vor Ort mit geringem Aufwand herstellen lassen. Ungezählten Strom führende, an die Aufnahmebaugruppen angeschlossene Leiter werden durch eine Öffnung in der Zählertragplatte 2b hindurchgeführt, die sich mit Hilfe der Schwachstellen 33 ausbrechen lässt.

Die vorangehend wie auch letztgenannten Anschlussleitungen können diejenigen sein, die vorher in Verbindung mit dem auf Zählertragplatte 3b' angebrachten herkömmlichen Zähler verwendet wurden und durch eine Öffnung in der Zählertragplatte 3b' hindurch verlegt sind.

Fig. 7 zeigt die Möglichkeit, anstelle der beiden, unmittelbar aneinander angrenzend angeordneten Aufnahmebaugruppen 9b, 10b nur eine dieser beiden Aufnahmebaugruppen zu verwenden und in der Mitte der Zählertragplatte 2b anzuordnen. Entsprechend werden geeignete Felder des Randstegs 11 b ausgebrochen, um in der Mitte des betreffenden Wandabschnitts eine Einführungsöffnung für das obere Ende dieser Aufnahmebaugruppe 9b zu bilden. Auch für die einzelne Aufnahmebaugruppe lässt sich die Abdeckhaube 41 für die ungezählten Strom führenden Leitungen verwenden. Die durch die Stege 40 gehaltenen Abdeckhauben 41 sind bei aufgesetztem und plombierten Stromzähler durch Formschluss mitplombiert und die ungezählten Strom führenden Leitungen somit vor dem Zugriff durch Unbefugte gesichert.

Gemäß Fig. 9 ist auf der Zählertragplatte 2b eine Aufnahmebaugruppe 45 angebracht, die sich von den vorangehend gezeigten Aufnahmebaugruppen dadurch unterscheidet, dass nur eine einzige Klemmanschlussleiste 46 vorgesehen ist, an der sowohl gezählten als auch ungezählten Strom führende Leitungen anschließbar sind. Die Aufnahmebaugruppe 45 reicht unmittelbar an den Randsteg 11 b heran. Einrichtungen zur Abdeckung der angeschlossenen Leitungen sind in Fig. 9 nicht gezeigt.

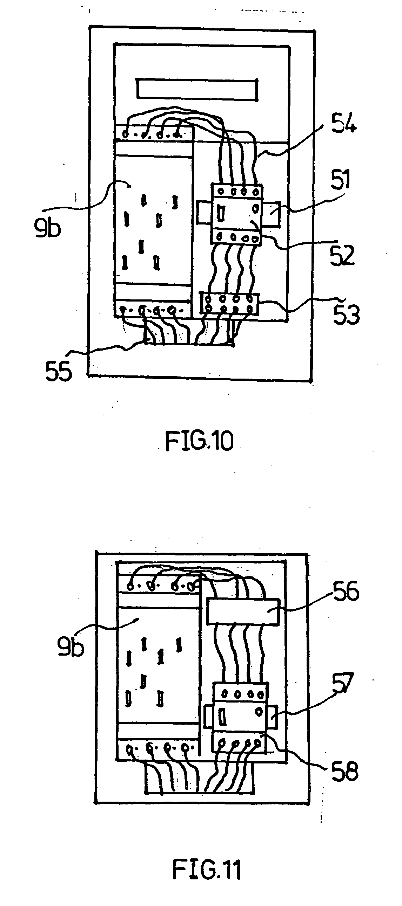

Das Ausführungsbeispiel von Fig. 10 weist nur eine Aufnahmebaugruppe 9b für einen Zähler auf. Der Platz für eine zweite Aufnahmebaugruppe ist für eine Hutprofilschiene 51, auf der Schaltvorrichtungen 52 montiert sind, genutzt. Unterhalb der Schaltvorrichtung 52 ist dort ferner eine Anschlussleiste 53 untergebracht.

Gezählten Strom führende Leitungen 54 führen zu der Schaltvorrichtung 52 und von dort zu der Anschlussleiste 53. So können ursprüngliche Anschlussleitungen, die durch eine Öffnung 55 in der hinteren Zählertragplatte geführt sind, unmittelbar ohne Lageveränderung für den elektronischen Stromzähler des Anschlussplatzes genutzt werden.

Bei dem Ausführungsbeispiel von Fig. 11 sind zwei Hutprofilschienen 56 und 57 vorgesehen, von denen die Hutprofilschiene 57 eine Schaltvorrichtung 58 trägt. Auch hier können ursprüngliche Anschlussleitungen unmittelbar angeschlossen werden.

## Patentansprüche

1. Zähleranschlussplatz mit einer Zählertragplatte (2) zur Aufnahme von wenigstens zwei Stromzählern (5,6),
**dadurch gekennzeichnet,**
**dass** die Zählertragplatte (2) zur Anbringung an einer dahinterliegenden weiteren Zählertragplatte (3') vorgesehen ist.

2. Zähleranschlussplatz nach Anspruch 1,
**dadurch gekennzeichnet,**
**dass** die Zählertragplatte (2) parallel zu der weiteren Zählertragplatte (3') angeordnet und mit dieser deckungsgleich oder geringfügig kleiner als die weitere Zählertragplatte (3') ist.

3. Zähleranschlussplatz nach Anspruch 1 oder 2,
**dadurch gekennzeichnet,**
**dass** sich die Zählertragplatte (2), ggf. klemmend, zwischen Randstegen (22) der weiteren Zählertragplatte (3') auf die weitere Zählertragplatte (3') aufsetzen lässt.

4. Zähleranschlussplatz nach einem der Ansprüche 1 bis 3,
**dadurch gekennzeichnet,**
**dass** die Zählertragplatte (2) zur Verbindung mit einem an der weiteren Zählertragplatte (3') angebrachten Zählerkreuzschenkel (7,8) vorgesehen ist.

5. Zähleranschlussplatz nach einem der Ansprüche 1 bis 4,
**dadurch gekennzeichnet,**
**dass** die Zählertragplatte (2) mit einem, ggf. geschlossen umlaufenden Randsteg (21) gegen die weitere Zählertragplatte (3') unter Bildung eines Hohlraums zwischen den Zählertragplatten (2,3') anliegt.

6. Zähleranschlussplatz nach einem der Ansprüche 1 bis 5,
**dadurch gekennzeichnet,**
**dass** für die beiden Stromzähler (5,6) als Gesamtheit an der Zählertragplatte (2) anbringbare, sämtliche zur elektrischen und mechanischen Ankopplung der Stromzähler erforderlichem Elemente aufweisende Aufnahmebaugruppen (9,10) vorgesehen sind.

7. Zähleranschlussplatz nach Anspruch 6,
**dadurch gekennzeichnet,**
**dass** die Aufnahmebaugruppen (9,10) in Öffnungen (13,14) in der Zählertragplatte (2,2a) einsenkbar oder auf die Zählertragplatte (2b) aufsetzbar sind.

8. Zähleranschlussplatz nach Anspruch 6 oder 7,
**dadurch gekennzeichnet,**
**dass** die Aufnahmebaugruppen (9,10) ein im Wesentlichen quaderförmiges Gehäuse aufweisen.

9. Zähleranschlussplatz nach einem der Ansprüche 6 bis 8,
**dadurch gekennzeichnet,**
**dass** die Aufnahmebaugruppen (9,10) unter Bildung eines Verdrahtungskanals (23) zueinander im Abstand oder unmittelbar aneinander angrenzend angeordnet sind.

10. Zähleranschlussplatz nach einem der Ansprüche 6 bis 9,
**dadurch gekennzeichnet,**
**dass** die Aufnahmebaugruppen (9,10) jeweils auf einander gegenüberliegenden Seiten permanent mit Anschlussleitungen (15) verbunden sind oder Klemmen, vorzugsweise Klemmleisten (42), zum Anschluss von Leitungen aufweisen.

11. Zähleranschlussplatz nach Anspruch 10,
**dadurch gekennzeichnet,**
**dass** an die Aufnahmebaugruppen (9,10) auf der jeweiligen einen Seite ungezählten Strom führende Leitungen und auf der anderen Seite gezählten Strom führende Leitungen anklemmbar sind.

12. Zähleranschlussplatz nach einem der Ansprüche 1 bis 11,
**dadurch gekennzeichnet,**
**dass** die Zählertragplatte (2) eine Öffnung oder Schwachstellen (33) zur Bildung einer Öffnung für die Durchführung von Leitungen aufweist.

13. Zähleranschlussplatz nach Anspruch 12,
**dadurch gekennzeichnet,**
**dass** die Schwachstellen (33) zur Bildung der Öffnung in unterschiedlicher Größe oder/und unterschiedlicher Anordnung vorgesehen sind.

14. Zähleranschlussplatz nach Anspruch 13,
**dadurch gekennzeichnet,**
**dass** sich die Öffnung mit einer Öffnung zum Durchführen von Leitungen in der weiteren Zählertragplatte (3') zur Deckung bringen lässt.

15. Zähleranschlussplatz nach einem der Ansprüche 1 bis 13,
**dadurch gekennzeichnet,**
**dass** die Zählertragplatte (2) zur Aufnahme zusätzlicher Geräte, die vorzugsweise einer Datenübertragung dienen, oder zur Aufnahme von Schaltvorrichtungen vorgesehen ist.

16. Zähleranschlussplatz nach Anspruch 15,
**dadurch gekennzeichnet,**
**dass** am oberen Ende der Zählertragplatte (2) von der Zählertragplatte (2) ein Steg (11) zur Bildung eines separaten, durch eine Abdeckung (28) verschließbaren Aufnahmeraums (32) für die Geräte vorstehen.

17. Zähleranschlussplatz nach Anspruch 16,
**dadurch gekennzeichnet,**
**dass** der den Aufnahmeraums (32) bildende Steg (11 b) Schwachstellen (34) für die Bildung von Öffnungen aufweist, durch welche hindurch die Aufnahmebaugruppen (9b, 10b) in den Aufnahmeraum (32) hineinragen.

18. Zähleranschlussplatz nach Anspruch 17,
**dadurch gekennzeichnet,**
**dass** Schwachstellen (34) zur Bildung von Öffnungen in unterschiedlichen Positionen vorgesehen sind.

19. Zähleranschlussplatz nach einem der Ansprüche 4 bis 18,
**dadurch gekennzeichnet,**
**dass** an der der weiteren Zählertragplatte (3') zugewandten Seite der Zählertragplatte Haken für die Verbindung der Zählertragplatte mit einem horizontalen Zählerkreuzschenkel vorgesehen sind.

20. Zählertragplatte (2) zur Aufnahme von mindestens zwei Stromzählern (5,6) für einen Zähleranschlussplatz nach einem der Ansprüche 1 bis 19.
